# EUROPEAN PATENT SPECIFICATION

(11) **EP 4 362 069 B1**
(45) Date of publication and mention of the grant of the patent: **08.10.2025**
(21) Application number: 21953087.0
(22) Date of filing: 10.08.2021
(51) Int. Cl.: H01L 23/62, H05K 1/02, H01L 23/00, H05K 1/18, H01L 23/49, H01H 85/046, H01L 21/50, H01L 23/488, H01H 85/00, H05K 1/00, H01L 23/525, H01L 23/48, H01L 23/498, H01L 23/538

(54) **PACKAGING STRUCTURE AND ELECTRONIC APPARATUS**
VERPACKUNGSSTRUKTUR UND ELEKTRONISCHE VORRICHTUNG
STRUCTURE DE BOÎTIER ET APPAREIL ÉLECTRONIQUE

(43) Date of publication of application: 01.05.2024
(73) Proprietor: Huawei Technologies Co., Ltd., Shenzhen, Guangdong 518129 (CN)
(72) Inventor: WU, Ming, Shenzhen, Guangdong 518129 (CN); XIANG, Zhiqiang, Shenzhen, Guangdong 518129 (CN); DING, Fei, Beijing 100029 (CN); WANG, Qidong, Beijing 100029 (CN)
(74) Representative: Gill Jennings & Every LLP
(86) International application number: PCT/CN2021/111866
(87) International publication number: WO 2023/015456

(56) References cited:
- CN-A- 101 595 546
- CN-A- 103 098 165
- CN-A- 112 687 646
- CN-A- 112 687 646
- JP-A- H0 537 148
- JP-A- H0 878 611
- US-A1- 2002 140 540
- US-A1- 2006 273 876

## Description

### TECHNICAL FIELD

This application relates to the field of semiconductor technologies, and in particular, to a package structure and an electronic apparatus.

### BACKGROUND

Surface-mount technology (surface-mount technology, SMT) is currently one of the most popular technologies and processes in the electronic assembly industry. Since the SMT was launched to market in the early 1970s, the SMT has gradually replaced a traditional "manual plug-in" wave soldering assembly manner, and has become a mainstream of the modern electronic assembly industry. The SMT promotes development of electronic components toward a direction of a chip type, miniaturization, thinness, lightweight, high reliability, and multi-function.

A power semiconductor device such as a power supply is soldered on a printed circuit board (printed circuit board, PCB) in an SMT secondary package manner to supply power to a board. However, once an overcurrent (excess current) occurs in the power semiconductor device, a large amount of heat is generated. This is prone to causing damage to the printed circuit board, and even causes "board burning" in a serious case. The overcurrent means an abnormal current carried by an electrical element, that is, the current exceeds a normal through-current range. JPH0537148A describes a surface-mount type semiconductor device for easy removal from a mounting section. CN112687646A describes a self-loss-proof power SIP module packaging structure and packaging method thereof.

### SUMMARY

The scope of the invention is set out in the appended claims. Embodiments of this application provide a package structure and an electronic apparatus that have an overcurrent self-protection capability.

According to a first aspect, this application provides a package structure, including a power semiconductor device, a wire, and a shape memory object. The wire is electrically connected to the power semiconductor device, the shape memory object is in contact with the wire, and the shape memory object is configured to deform when temperature of the shape memory object is not less than preset temperature, to enable a current in the wire to be cut off.

The preset temperature is temperature at which the shape memory object begins to deform. A wire current cutoff means that a current in the wire is cut off.

According to the heat formula Q = I²R, where Q represents heat, I represents a current, and R represents impedance, the power semiconductor device generates heat when an overcurrent occurs in the power semiconductor device, and therefore external temperature rises. The external temperature means temperature of an environment in which the shape memory object is located. The heat generated by the power semiconductor device when an overcurrent occurs in the power semiconductor device is conducted to the shape memory object. The temperature of the shape memory object rises. When the temperature of the shape memory object rises to the preset temperature, the shape memory object begins to deform. The deformation of the shape memory object causes a current in the wire to be cut off, thereby reducing the heat generated, and delaying the rise of the external temperature. This reduces impact of an overcurrent of the power semiconductor device on a printed circuit board, greatly reduces a possibility of damage to the printed circuit board, and implements an overcurrent self-protection capability of the package structure. In other words, the shape memory object is an overcurrent protection structure of the package structure, that is, the package structure has an overcurrent (over-temperature) self-protection capability. Even if the power semiconductor device is damaged due to an overcurrent, the burnt package structure may be directly removed, and the printed circuit board may be reserved for reuse.

That the shape memory object is in contact with the wire includes that the shape memory object is in insulated contact with the wire.

When the shape memory object is in insulated contact with the wire, the shape memory object deforms when the temperature of the shape memory object reaches the preset temperature, to apply a stress generated during the deformation to the wire, to enable the wire to be broken and a current in the wire to be cut off.

Generally, the wire is a copper wire. Resistivity of the shape memory object is generally more than 20 times resistivity of the copper wire. When an overcurrent occurs in the power semiconductor device, because the resistivity of the shape memory object is relatively high, a large amount of heat is concentrated on the shape memory object, and the shape memory object is fused, to enable a current in the wire to be cut off.

The deformation of the shape memory object may cause the wire to be broken due to the stress generated when the shape memory object deforms, so that a current in the wire is cut off.

According to the first aspect, in a first possible implementation of the first aspect of this application, the wire is at least partially packaged in the shape memory object, and the stress generated when the shape memory object deforms acts on the wire, to break the wire.

The wire is at least partially packaged in the shape memory object. To be specific, the shape memory object surrounds an outer wall of at least a part of the wire, so that a contact area between the shape memory object and the wire can be increased. When the shape memory object deforms, the shape memory object arches, so that the part of the wire the shape memory object surrounds is bent and broken by force.

According to the first aspect or the first possible implementation of the first aspect of this application, in a second possible implementation of the first aspect of this application, the shape memory object is a polymer having one-way shape memory effect, or ceramic having one-way shape memory effect.

According to the first aspect or the first implementation and the second possible implementation of the first aspect of this application, in a third possible implementation of the first aspect of this application, the package structure further includes a package medium, the shape memory object is a shape memory alloy having one-way shape memory effect, the shape memory object is packaged in the package medium, and the shape memory object is configured to deform when the temperature of the shape memory object reaches the preset temperature. In this way, a current in the wire may be cut off.

In one case, when the shape memory object deforms, the shape memory object arches, so that a surrounding package medium and/or a surrounding wire deform/deforms, and the wire is bent and broken by force.

In one case, when the temperature of the shape memory object reaches the preset temperature, the shape memory object elongates. This increases the impedance of the through-current structure formed by the shape memory object and the wire, and reduces a current in the wire, thereby reducing a possibility of an overcurrent of the wire. For example, the resistivity of the shape memory object is greater than the resistivity of the wire. According to the formula Q = I²R, when an overcurrent still occurs in the wire, because the resistivity of the shape memory object is greater than the resistivity of the wire, heat is concentrated on the shape memory object to fuse the shape memory object, to enable a current in the wire to be cut off.

According to the first aspect or the first implementation to the third possible implementation of the first aspect of this application, in a fourth possible implementation of the first aspect of this application, the wire includes a first extension part, a second extension part, and a connection part, a first end of the connection part is in electrical contact with the first extension part, a second end of the connection part is in electrical contact with the second extension part, and the shape memory object is located between the first extension part and the second extension part.

According to the first aspect or the first implementation to the fourth possible implementation of the first aspect of this application, in a fifth possible implementation of the first aspect of this application, the shape memory object and the connection part of the wire are disposed at a spacing.

According to the first aspect or the first implementation to the fifth possible implementation of the first aspect of this application, in a sixth possible implementation of the first aspect of this application, the shape memory object is disposed around an outer wall of the connection part.

According to the first aspect or the first implementation to the sixth possible implementation of the first aspect of this application, in a seventh possible implementation of the first aspect of this application, the shape memory object is disposed closely adjacent to the connection part.

According to the first aspect or the first implementation to the seventh possible implementation of the first aspect of this application, in an eighth possible implementation of the first aspect of this application, the shape memory object is a shape memory alloy having one-way shape memory effect, the package structure further includes a solder formation, the solder formation is fastened to the wire, the solder formation is located outside the package medium, the shape memory object is implanted into the solder formation, one end of the shape memory object is electrically connected to the wire, the other end of the shape memory object is configured to be electrically connected to the printed circuit board, and the shape memory object is configured to elongate when the temperature of the shape memory object reaches the preset temperature, to increase the impedance of the through-current structure of the package structure, thereby reducing a current in the wire.

That the shape memory object is implanted into the solder formation means that the shape memory object is embedded in the solder formation and is surrounded by the solder formation. The solder formation includes solder. While the package structure implements overcurrent protection, an internal line structure of the package structure does not need to be changed, thereby facilitating preparation of the package structure.

According to the first aspect or the first implementation to the eighth possible implementation of the first aspect of this application, in a ninth possible implementation of the first aspect of this application, the shape memory object is of an elastic structure, and an initial state of the shape memory object is a compressed state or a natural state.

The initial state of the shape memory object is the compressed state. When the temperature of the shape memory object is not less than the preset temperature, the shape memory object elongates. An elastic force of the shape memory object, in combination with the stress generated when the shape memory object deforms, acts on the wire, to enable the wire to be broken.

According to a second aspect, this application provides an electronic apparatus, including the package structure according to the first aspect or the first implementation to the ninth possible implementation of the first aspect of this application and a printed circuit board. A control circuit is disposed on the printed circuit board, the package structure is fastened to the printed circuit board by using a solder formation, the wire of the package structure is electrically connected to the control circuit on the printed circuit board, and the control circuit is configured to control the power semiconductor device to turn on or off.

### BRIEF DESCRIPTION OF DRAWINGS

FIG. 1 is a schematic diagram of an electronic apparatus according to a first implementation of this application;
FIG. 2 is a schematic diagram of a package body according to a first implementation of this application;
FIG. 3a is a schematic diagram of an initial state of a shape memory object;
FIG. 3b is a schematic diagram of a possible bending structure formed when a shape memory object deforms;
FIG. 3c is a schematic diagram of another possible bending structure formed when a shape memory object deforms;
FIG. 4 is a schematic diagram of a possible structure of a package body;
FIG. 5 is a schematic diagram of a package structure according to a second implementation of this application;
FIG. 6a is a schematic diagram of a possible structure formed when the connection part of a wire and a shape memory object are disposed at a spacing and temperature of the shape memory object is less than preset temperature;
FIG. 6b is a schematic diagram of a possible structure formed when the connection part of a wire and a shape memory object are disposed at a spacing and temperature of the shape memory object is not less than preset temperature;
FIG. 7a is a schematic diagram of a possible structure formed when a shape memory object is disposed around a wire and temperature of the shape memory object is less than preset temperature;
FIG. 7b is a schematic diagram of a possible structure formed when a shape memory object is disposed around a wire and temperature of the shape memory object is not less than preset temperature;
FIG. 8 is a schematic diagram of another possible structure formed when a shape memory object is disposed around a wire and temperature of the shape memory object is not less than preset temperature;
FIG. 9a is a schematic diagram of a possible structure formed when a shape memory object attaches a wire and temperature of the shape memory object is less than preset temperature;
FIG. 9b is a schematic diagram of a possible structure formed when a shape memory object attaches a wire and temperature of the shape memory object is not less than preset temperature; and
FIG. 10 is a schematic diagram of an electronic apparatus according to a third implementation of this application;

### DESCRIPTION OF EMBODIMENTS

A package structure of a power semiconductor device such as a power supply is soldered on a printed circuit board for power supply. Other electronic components are generally disposed on the printed circuit board. The package structure includes a power semiconductor device, a wire, and a package medium (also referred to as a plastic package body). Both the power semiconductor device and the wire are packaged in the package medium. A material of the wire is generally copper. A melting point of copper is about 1085°C. The power semiconductor device is generally an integrated circuit (that is, a Si chip) disposed on a Si substrate. Si has tolerable temperature up to 1414°C. The printed circuit board generally has tolerable temperature of approximately 350°C. It may be seen that the printed circuit board has the lowest tolerable temperature.

However, the power semiconductor device generates heat once an overcurrent occurs in the power semiconductor device, and therefore external temperature rises. The external temperature is temperature of an environment in which the package structure is located. In particular, when an overcurrent occurs in the power semiconductor device, a burning phenomenon may occur, and a flame spreads to the package medium and the printed circuit board along the wire. Because the tolerable temperature of the printed circuit board is relatively low, when the external temperature exceeds the tolerable temperature of the printed circuit board, the high temperature is prone to causing damage to the printed circuit board. Therefore, an overcurrent of a power semiconductor device may cause a whole printed circuit board to be scrapped.

In view of this, this application provides a package structure including a power semiconductor device. The power semiconductor device generates heat when an overcurrent occurs in the power semiconductor device, and a shape memory object can deform when temperature of the shape memory object is not less than preset temperature, to enable t a current in the wire to be cut off. This implements an overcurrent (over-temperature) self-protection capability of the package structure, and reduces a possibility that a printed circuit board is damaged, thereby improving security and reliability of an electronic apparatus.

The package structure provided in this application may be applied to various electronic apparatuses that need to use a power semiconductor device. The power semiconductor device is configured to perform power conversion processing, including frequency conversion, voltage conversion, current conversion, power management, and the like. The electronic apparatus may be an electric energy conversion apparatus that needs to use a power semiconductor device. The electric energy conversion apparatus may further be carried on an electric energy conversion device to complete various electric power functions of the device. For example, the electronic apparatus in this application may be applied to the field of electric vehicle power systems, that is, the electric energy conversion device may be an electric vehicle. The electronic apparatus may be a motor controller, and the package structure is a power conversion unit assembled in the motor controller. The electronic apparatus may alternatively be an on-board charger (on-board charger, OBC), and the package structure is an energy conversion unit. The electronic apparatus may additionally be a low-voltage control power supply, and the package structure is a DC-DC conversion unit or the like in the electronic apparatus. In addition, the electronic apparatus in this application is not limited to the field of electric vehicles, and may further be widely applied to fields of conventional industrial control, communication, a smart grid, an electric appliance, and the like. For example, the electronic apparatus may be applied to an uninterruptible power supply (uninterruptible power supply, UPS) of a data center, an inverter of a photovoltaic power generation device, a power supply of a server, a switch-mode power supply of an electric appliance (for example, a refrigerator), and the like. It may be understood that, the electronic apparatus is not limited to the electric energy conversion apparatus in this application. To be specific, the power semiconductor device is not limited to performing electric energy conversion in this application. The power semiconductor device may alternatively be configured to change a voltage, a frequency, or the like, in the electronic apparatus, to implement a circuit control function.

The following further describes in detail this application with reference to accompanying drawings.

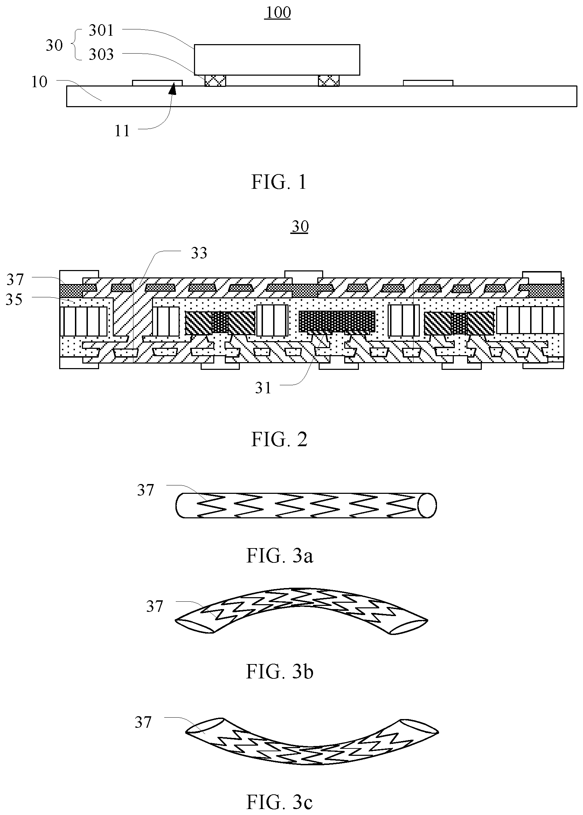

Refer to FIG. 1. A first implementation of this application provides an electronic apparatus 100, including a printed circuit board 10 and a package structure 30 soldered on the printed circuit board 10. In this implementation, the printed circuit board 10 may be a network board.

The package structure 30 includes a package body 301 and a solder formation 303. The package body 301 is soldered on the printed circuit board 10 by using the solder formation 303. In this implementation, the package structure 30 is an embedded component packaging (embedded component packaging, ECP) structure. The solder formation 303 is formed between the package body 301 and the printed circuit board 10 by using a reflow soldering process, so that the package body 301 is soldered on the printed circuit board 10. In the reflow soldering process, air or nitrogen is heated up to high enough temperature and then blown to a printed circuit board to which a component has been attached, so that solder on both sides of the component is melted to bond with the printed circuit board. The solder formation 303 is located outside the package body 301. Generally, soldering temperature of the reflow soldering process is 260°C. It may be understood that the solder formation 303 may alternatively be pre-installed on the package body 301.

Refer to FIG. 2. The package body 301 includes a power semiconductor device 31, a wire 33, a package medium 35, and a shape memory object 37. The power semiconductor device 31 is packaged in the package medium 35, and a part of the wire 33 is packaged in the package medium 35. The power semiconductor device 31 is electrically connected to the wire 33. A control circuit 11 is disposed on the printed circuit board 10 (as shown in FIG. 1). The control circuit 11 includes but is not limited to electronic components such as a capacitor and an inductor. The wire 33 is electrically connected to the control circuit 11 of the printed circuit board 10. The control circuit 11 is configured to control the power semiconductor device 31 to turn on or off to implement power conversion. A remaining part of the wire 33 is packaged in the shape memory object 37. To be specific, a part of the wire 33 is in insulated contact with the shape memory object 37. The shape memory object 37 is configured to deform when temperature of the shape memory object 37 is not less than preset temperature, to enable the wire 33 to be broken and a current in the wire 33 to be cut off. It may be understood that the package body 301 may further include another component, for example, a capacitor.

The preset temperature is temperature at which the shape memory object begins to deform (perform phase transformation). The power semiconductor device 31 generates heat when an overcurrent occurs in the power semiconductor device 31, and therefore external temperature rises. The external temperature means temperature of an environment in which the shape memory object 37 is located. The heat generated by the power semiconductor device 31 when an overcurrent occurs in the power semiconductor device 31 is conducted to the shape memory object 37. When the temperature of the shape memory object 37 rises to the preset temperature, the shape memory object 37 deforms. A stress generated when the shape memory object 37 deforms acts on the wire 33, to enable the wire 33 to be broken, thereby implementing a current cutoff of the wire 33. Because of the current cutoff of the wire 33, the heat generated is reduced. This delays the rise of the external temperature, reduces impact of the external temperature on the printed circuit board 10, and reduces a possibility that the printed circuit board 10 is damaged. In other words, the shape memory object 37 is an overcurrent protection structure of the package structure 30. When an overcurrent occurs in the power semiconductor device 31, the shape memory object 37 deforms and causes a current in the wire 33 to be cut off. To be specific, the package structure 30 has an overcurrent self-protection capability, thereby prolonging a service life of the printed circuit board 10. When the package structure 30 in a printed circuit board assembly 100 is damaged when an overcurrent occurs in the package structure 30, the damaged package structure 30 may be directly removed, and the printed circuit board 10 may be reserved for reuse.

That the power semiconductor device 31 is packaged in the package medium 35 means that the package medium 35 wraps (or surrounds) the power semiconductor device 31. That a part of the wire 33 is packaged in the package medium 35 means that the package medium 35 wraps (or surrounds) the part of the wire 33. A remaining part of the wire 33 is packaged in the shape memory object 37. That a remaining part of the wire 33 is packaged in the shape memory object 37 means that the shape memory object 37 covers at least a part of an outer surface of the wire 33. In other words, the shape memory object 37 is also used as a plastic package body of the package structure 30 to perform plastic packaging on the wire 33.

In this implementation, the wire 33 is a copper wire. It may be understood that the wire 33 may be a wire of another material, for example, gold. A material of the wire 33 is not limited in this application.

In this implementation, the package medium 35 is an ajinomoto build-up film (ajinomoto build-up film, ABF film). It may be understood that the package medium 35 is not limited to the ABF film, and may alternatively be a plastic package body of another material.

In this implementation, the shape memory object 37 and the package medium 35 are disposed in a stacked manner. In this implementation, the shape memory object 37 is disposed close to the outermost layer of the package medium 35 and is disposed on a side that is of the package body 301 and that is away from the printed circuit board 10 (as shown in FIG. 1), so that the shape memory object 37 is conveniently disposed on the package medium 35.

In this implementation, the shape memory object 37 is a polymer having one-way shape memory effect. The one-way shape memory effect means that the shape memory object 37 can recover deformation at low temperature when the shape memory object 37 is heated up and when the temperature rises. The shape memory object 37 is an intelligent thermosensitive polymer. The intelligent thermosensitive polymer is a polymer material that can make a predetermined response to a temperature change of the polymer. In other words, the temperature change of the polymer causes a microstructure of the polymer to make the predetermined response, so that specific macro performance of the polymer changes accordingly. A thermosensitive shape memory polymer is a kind of intelligent material. After deformation and fastening, the polymer can automatically return to an initial shape under a specific external condition (thermal stimulation). It may be understood that the shape memory object 37 may alternatively be ceramic having one-way shape memory effect.

The shape memory object 37 deforms when the temperature of the shape memory object 37 is not less than the preset temperature, and the stress generated when the shape memory object 37 deforms acts on the wire 33, to enable the wire 33 to be bent and broken by force. For example, an initial shape of the shape memory object 37 is a flat shape (as shown in FIG. 3a). When the temperature of the shape memory object 37 is less than the preset temperature, the shape memory object 37 maintains the initial shape. The power semiconductor device 31 releases heat when an overcurrent occurs in the power semiconductor device 31, so that the external temperature rises. The temperature of the shape memory object 37 rises with the rise of the external temperature. When the temperature of the shape memory object 37 is not less than the preset temperature, the shape memory object 37 deforms to form a bending structure. For example, the shape memory object 37 may form an arched structure shown in FIG. 3b or FIG. 3c. A stress generated when the shape memory object 37 bends and arches acts on the wire 33, and the wire 33 is bent and broken by force, to implement current cut-off of the wire 33.

If the preset temperature is excessively low, when reflow soldering is performed between the package body and the printed circuit board, the shape memory object deforms due to temperature of the reflow soldering. If the preset temperature is excessively high, when an overcurrent (for example, an overcurrent short circuit) occurs in the power semiconductor device, the temperature of the shape memory object needs a relatively long time to rise to the preset temperature. As a result, the shape memory object can hardly respond to the overcurrent of the power semiconductor device in time, and a consequence of damaging the printed circuit board is caused. In this implementation, the preset temperature is greater than 260°C but not greater than 500°C, so that the shape memory object 37 can resist the high temperature when the reflow soldering is performed between the package body 301 and the printed circuit board 10, and the shape memory object 37 may deform in a relatively short time (when temperature of the power semiconductor device 31 is not high at an early stage of an overcurrent) when an overcurrent occurs in the power semiconductor device 31 for response.

It may be understood that a range of the preset temperature is not limited in this application, and the preset temperature may be set according to a requirement.

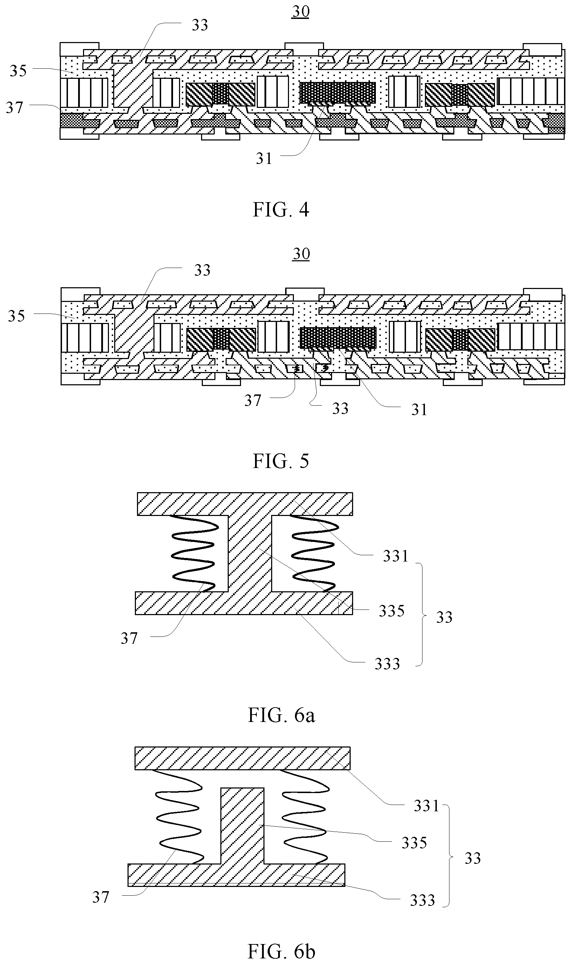

It may be understood that a position of the shape memory object 37 in the package body 301 is not limited, and at least a part of the wire 33 is packaged in the shape memory object 37. For example, the shape memory object 37 is disposed close to the outermost layer of the package medium 35 and is disposed on a side that is of the package body 301 and that is close to the printed circuit board 10 (as shown in FIG. 4), or the shape memory object 37 is wrapped by the package medium 35.

In some implementations, the shape memory object 37 replaces all package media 35. To be specific, the power semiconductor device 31 is packaged in the shape memory object 37, and the wire 33 is packaged in the shape memory object 37.

Refer to FIG. 5. A difference between a package structure provided in a second implementation of this application and the package structure provided in the first implementation lies in that a shape memory object 37 is a shape memory alloy, and the shape memory object 37 is in electrical contact with a wire 33.

Specifically, a package structure 30 includes a through-current structure, and the through-current structure includes the wire 33 and the shape memory object 37. The shape memory object 37 is connected to the wire 33 through fastening, and the shape memory object 37 is electrically connected to the wire 33. In other words, the shape memory object 37 is used as a part of the through-current structure of the package structure 30.

The shape memory object 37 is a shape memory alloy. The shape memory alloy (shape memory alloy, SMA) is a functional metal material with a shape memory effect and superelasticity. For a general metal material, when deformation of the material exceeds an elastic limit, permanent deformation occurs in the material. Such deformation is known as plastic deformation, and cannot be completely recovered by heating up or unloading a stress from the material when the material is in a solid state. However, a case of the shape memory alloy is different. The shape memory alloy has a shape memory effect and superelasticity. To be specific, a solid-state material with a specific shape undergoes plastic deformation at relatively low temperature or when a stress is increased, but when the temperature rises or the stress decreases, the shape memory alloy can recover to the shape obtained before the deformation.

Based on different deformation and recovery manners, shape memory effects may be divided into three types: one-way shape memory effect, a two-way shape memory effect, and a whole-process shape memory effect. The one-way shape memory effect means that an alloy can recover deformation at low temperature when the alloy is heated up and when the temperature rises. After special heat treatment is performed on some alloys, the alloys can not only recover deformation at low temperature, but also recover deformation at high temperature during phase transformation when the temperature decreases. This is known as the two-way shape memory effect. A shape memory alloy with the two-way shape memory effect that presents opposite shapes at low temperature and high temperature is known as the whole-process shape memory effect.

Table 1 shows an example of tensile strength, an elongation percentage, austenite phase transformation start temperature (As), and a shape memory recovery strain of some titanium-based high-temperature memory alloys. A titanium-based high-temperature memory alloy whose austenite phase transformation start temperature (As) is greater than 260°C but not greater than 500°C may be selected for application in the second implementation.

According to the law of resistance formula R = ρL/S, where ρ represents resistivity, L represents length, and S represents an area, when L increases and/or S decreases, impedance increases. The shape memory object 37 elongates when temperature of the shape memory object 37 is not less than preset temperature, so that impedance of the through-current structure is increased and a possibility of an overcurrent of the wire 33 is reduced. In this implementation, the wire 33 is a copper wire, and resistivity of the shape memory object 37 is more than 20 times that of the wire 33. When the temperature of the shape memory object 37 is not less than the preset temperature, because the shape memory object 37 elongates after deformation, a contact area between the shape memory object 37 and the wire 33 is at least one percent smaller than a contact area between the wire 33 and the wire 33. According to the law of resistance, impedance of the through-current structure obtained after the shape memory object 37 deforms is more than 2000 times original impedance of the through-current structure obtained when the shape memory object 37 does not deform.

**Table 1 Tensile strength, elongation percentage, austenite phase transformation start temperature (As), and shape memory recovery strain of some titanium-based high-temperature memory alloys**

| Shape memory alloy | Tensile strength | Elongation percentage | Austenite phase transformation start temperature (As) | Shape memory recovery strain |
|---|---|---|---|---|
| Ti-25Ta-20Nb | 550 | 30.0 | 478 | 3.0 |
| Ti-30Ta-0.5Y | 554 | 23.0 | 500 | 4.3 |
| Ti-20Ta-10Zr | 769 | 15.0 | 750 | 4.6 |
| Ti-30Zr | 750 | 7.6 | 970 | 1.4 |
| Ti-20Zr-10Nb | 1150 | 15.0 | 903 | 5.5 |
| Ti-19.5Zr-10Nb-0.5Fe | 573 | 21.0 | 429 | 4.1 |
| Ti-16Zr-10Nb-4Ta | 559 | 16.0 | 477 | 4.0 |
| Ti-30Nb-3Pd | 430 | 6.8 | 678 | 2.0 |
| Ti-9.5Mo-4Nb-2V-3Al | -- | -- | 700 | 1.0 |

According to the formula Q = I²R, where Q represents heat, I represents a current, and R represents impedance, a power semiconductor device 31 releases heat when an overcurrent occurs in the power semiconductor device 31, so that an external temperature rises. The rise in the external temperature causes the temperature of the shape memory object 37 to rise. The shape memory object 37 elongates when the temperature of the shape memory object 37 is not less than the preset temperature, so that impedance of the through-current structure is increased, a current in the wire 33 is reduced, a possibility of an overcurrent of the wire 33 is reduced, heat generated is reduced, and temperature rise of the shape memory object 37 is delayed. When an overcurrent still occurs in the wire 33, because an impedance of the through-current structure obtained after the shape memory object 37 deforms is far greater than the original impedance of the through-current structure obtained when the shape memory object 37 does not deform, heat is concentrated on the shape memory object 37, so that the shape memory object 37 can be fused, thereby cutting off a current in the wire 33.

Refer to FIG. 6a. The wire 33 includes a first extension part 331, a second extension part 333, and a connection part 335. The first extension part 331 extends along a first direction (for example, a transverse direction in FIG. 6a). The second extension part 333 extends along the first direction (for example, the transverse direction in FIG. 6a). The first extension part 331 is electrically connected to the power semiconductor device 31. In this implementation, the shape memory object 37 is a shape memory alloy having one-way shape memory effect.

A first end of the connection part 335 is in electrical contact with the first extension part 331, a second end of the connection part 335 is in electrical contact with the second extension part 333, and the connection part 335 is located between the first extension part 331 and the second extension part 333. The shape memory object 37 and the connection part 335 are disposed at a spacing. In the second implementation, the shape memory object 37 is of an elastic structure. For example, the shape memory object 37 may be coiled into a columnar spring structure. It may be understood that the shape memory object 37 may alternatively be of an elastic structure in another shape.

Initial states of the shape memory object 37 include a natural state, a compressed state, and a stretched state. The shape memory object 37 is in the natural state without external force. A height of the shape memory object 37 in the compressed state is less than that in the natural state. A height of the shape memory object 37 in the stretched state is greater than that in the natural state. It is assumed that when the temperature of the shape memory object 37 is less than the preset temperature, a state of the shape memory object 37 is an initial state.

The initial state of the shape memory object 37 is the compressed state. When the temperature of the shape memory object 37 is not less than the preset temperature, the shape memory object 37 deforms and elongates. An elastic force of the shape memory object 37, in combination with the stress generated when the shape memory object 37 deforms, acts on the first extension part 331, so that the connection part 335 is detached from the first extension part 331 (as shown in FIG. 6b), and the wire 33 is directly broken. And/or an elastic force of the shape memory object 37, in combination with the stress generated when the shape memory object 37 deforms, acts on the second extension part 333, so that the connection part 335 is detached from the second extension part 333, and the wire 33 is broken. In this case, when the shape memory object 37 is not fused, the shape memory object 37 may directly break the wire 33 and cut off a current in the wire 33. There are two shape memory objects 37, and the connection part 335 is located between the two shape memory objects 37, to shorten duration of breaking the wire 33 and improve overcurrent protection efficiency of the package structure 30. It may be understood that a quantity of shape memory objects 37 is not limited in this application.

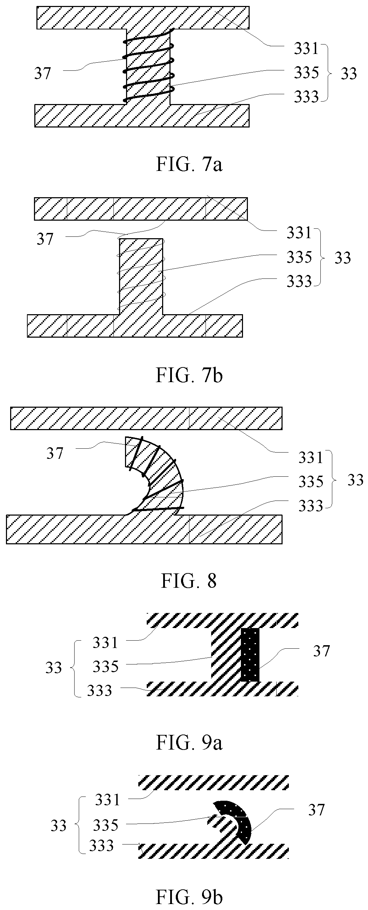

In some implementations, the shape memory object 37 is wound around (disposed around) an outer wall of the wire 33. As shown in FIG. 7a, the wire 33 includes the first extension part 331, the second extension part 333, and the connection part 335. The first extension part 331 extends along the first direction (for example, a transverse direction in FIG. 7a). The second extension part 333 extends along the first direction (for example, the transverse direction in FIG. 7a). The first end of the connection part 335 is in electrical contact with the first extension part 331, the second end of the connection part 335 is in electrical contact with the second extension part 333, and the connection part 335 is located between the first extension part 331 and the second extension part 333. The shape memory object 37 is wound around an outer wall of the connection part 335. The initial state of the shape memory object 37 is the compressed state. When the temperature of the shape memory object 37 is not less than the preset temperature, the shape memory object 37 elongates. An elastic force of the shape memory object 37, in combination with the stress generated when the shape memory object 37 deforms, acts on the first extension part 331, so that the connection part 335 is detached from the first extension part 331 (as shown in FIG. 7b), and the wire 33 is directly broken. And/or an elastic force of the shape memory object 37, in combination with the stress generated when the shape memory object 37 deforms, acts on the second extension part 333, so that the connection part 335 is detached from the second extension part 333, and the wire 33 is broken. In this case, when the shape memory object 37 is not fused, the shape memory object 37 may directly break the wire 33 and cut off a current in the wire 33. It may be understood that the initial state of the shape memory object 37 may alternatively be the natural state. Because the shape memory object 37 is limited by the first extension part 331 and the second extension part 333 during elongation, the shape memory object 37 is compressed.

In some implementations, the shape memory object 37 is wound around (disposed around) the outer wall of the wire 33 (as shown in FIG. 7a), and the initial state of the shape memory object 37 is the natural state. When the temperature of the shape memory object 37 is not less than the preset temperature, the shape memory object 37 elongates or bends. Because the shape memory object 37 is limited by the first extension part 331 and the second extension part 333 during elongation, the shape memory object 37 bends, so that the connection part 335 bends as the shape memory object 37 bends (as shown in FIG. 8). The bending and the deformation of the connection part 335 causes a contact area between the connection part 335 and the first extension part 331 to be reduced until the connection part 335 is detached from the first extension part 331, and/or the connection part 335 is detached from the second extension part 333.

In some implementations, the shape memory object 37 is disposed closely adjacent to the connection part 335 (as shown in FIG. 9a), and the initial state of the shape memory object 37 is the natural state. When the temperature of the shape memory object 37 is not less than the preset temperature, the shape memory object 37 elongates. Because the shape memory object 37 is limited by the first extension part 331 and the second extension part 333 during elongation, the shape memory object 37 bends, so that the connection part 335 deforms as the shape memory object 37 (as shown in FIG. 9b) bends. The bending and the deformation of the connection part 335 causes a contact area between the connection part 335 and the first extension part 331 to be reduced until the connection part 335 is detached from the first extension part 331, and/or the connection part 335 is detached from the second extension part 333.

It may be understood that an electrical contact manner between the shape memory object 37 and the wire 33 is not limited to the example in this application. The shape memory object 37 deforms when the temperature of the shape memory object 37 is not less than the preset temperature, and the stress generated when the shape memory object 37 deforms acts on the wire 33, to enable the wire 33 to be broken and a current in the wire 33 to be cut off.

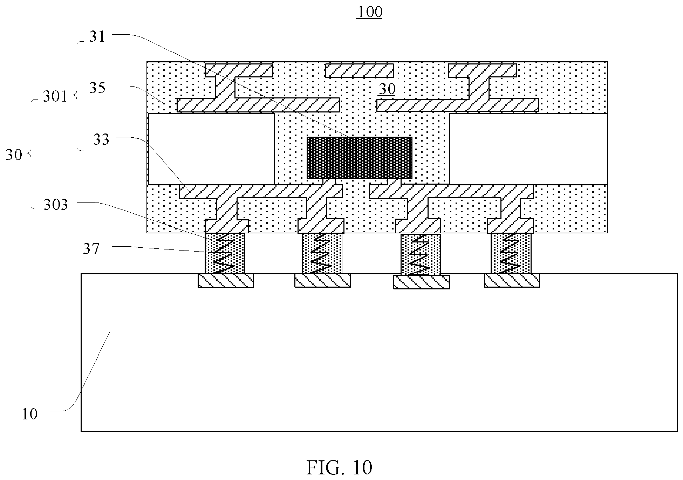

Refer to FIG. 10. A difference between an electronic apparatus 100 provided in a third implementation of this application and the electronic apparatus provided in the first implementation lies in that a shape memory object 37 is disposed outside a package body 301, the shape memory object 37 is implanted into a solder formation 303, the shape memory object 37 is electrically connected to a printed circuit board 10, and the shape memory object 37 is electrically connected to a wire 33.

Specifically, the package body 301 includes a power semiconductor device 31, the wire 33, and a package medium 35. The power semiconductor device 31 is packaged in the package medium 35, and a part of the wire 33 is packaged in the package medium 35. The power semiconductor device 31 is electrically connected to the wire 33.

The solder formation 303 includes but is not limited to solder. The solder formation 303 is located outside the package body 301. A first end of the solder formation 303 is connected to the wire 33 through fastening, and a second end of the solder formation 303 is connected to the printed circuit board 10 through fastening. The shape memory object 37 is implanted into the solder formation 303. A first end of the shape memory object 37 is in electrical contact with the wire 33, and a second end of the shape memory object 37 is in electrical contact with the printed circuit board 10. The wire 33 and the shape memory object 37 form a through-current structure.

That the shape memory object 37 is implanted into the solder formation 303 means that the shape memory object 37 is embedded in the solder formation 303 and is surrounded by the solder formation 303. A pad (not shown in the figure) is generally disposed on an outer surface of the package body 301. After the package body 301 is manufactured, the shape memory object 37 is placed at the pad, and the solder is cast on the shape memory object 37 to form the solder formation 303. In this way, the solder formation 303 and the shape memory object 37 are integrated. The solder formation 303 and the shape memory object 37 may be pre-installed on the package body 301, or may be manufactured on site when the package structure 30 is disposed on the printed circuit board 10.

The shape memory object 37 is a shape memory alloy. In this implementation, the shape memory object 37 is of an elastic structure. An initial state of the shape memory object 37 is a natural state. The shape memory object 37 elongates when temperature of the shape memory object 37 is not less than preset temperature, to reduce a contact area between the shape memory object 37 and the wire 33, thereby increasing impedance of the through-current structure. Because of the elongation of the shape memory object 37, the impedance of the through-current structure increases, and a current carried by the through-current structure decreases. When an overcurrent still occurs in the wire 33, because impedance of the through-current structure obtained after the shape memory object 37 deforms is far greater than original impedance of the through-current structure obtained when the shape memory object 37 does no deform, the overcurrent of the through-current structure generates a large amount of heat according to the formula Q = I²R. The large amount of heat generated by the overcurrent of the through-current structure is concentrated on the shape memory object 37, and the shape memory object 37 may be fused at high temperature, to cut off a current between the wire 33 and the printed circuit board 10.

It may be understood that the initial state of the shape memory object 37 may be a compressed state.

It may be understood that the initial state of the shape memory object 37 may be a natural state, and when the temperature of the shape memory object 37 is not less than the preset temperature, the shape memory object 37 elongates. Because the shape memory object 37 is limited by the package body 301 and the printed circuit board 10 in an elongation process, the shape memory object 37 bends, so that the solder formation 303 bends as the shape memory object 37 bends. The bending and the deformation of the solder formation 303 causes a contact area between the solder formation 303 and the package body 301 to be reduced until the solder formation 303 is detached from the package body 301, and/or a contact area between the solder formation 303 and the printed circuit board 10 until the solder formation 303 is detached from the printed circuit board 10.

When the package structure 30 implements overcurrent protection, a line structure inside the package structure 30 (that is, inside the package body 301) remains changed. This facilitates preparation of the package structure 30.

It should be understood that expressions such as "include" and "may include" that may be used in this application indicate existence of the disclosed function, operation, or constituent element, and do not limit one or more additional functions, operations, and constituent elements. In this application, terms such as "include" and/or "have" may be interpreted as representing a particular feature, quantity, operation, constituent element, component, or a combination thereof, but may not be construed as excluding existence or possible addition of one or more other features, quantities, operations, constituent elements, components, or a combination thereof.

In addition, in this application, the expression "and/or" includes any or all combinations of words listed in connection. For example, the expression "A and/or B" may include A, may include B, or may include both A and B.

In this application, expressions including ordinal numbers such as "first" and "second" may modify elements. However, such elements are not limited by the expressions. For example, the expressions do not limit an order and/or importance of the elements. The expressions are used only to distinguish one element from another. For example, first user equipment and second user equipment indicate different user equipment, although both the first user equipment and the second user equipment are user equipment. Similarly, without departing from the scope of this application, a first element may be referred to as a second element, and similarly, a second element may also be referred to as a first element.

When a component "connects" or "is connected" to another component, it should be understood that the component directly connects or is directly connected to the another component, or a further component may alternatively exist between the component and the another component. In addition, when a component "directly connects" or "directly connected" to another component, it should be understood that there is no component between them.

## Claims

1. A package structure (30), comprising a power semiconductor device (31), a wire (33), and a shape memory object (37), wherein the wire is electrically connected to the power semiconductor device, the shape memory object is in contact with the wire, and the shape memory object is configured to deform when temperature of the shape memory object reaches preset temperature, to enable a current in the wire to be cut off, wherein the shape memory object is in insulated contact with the wire, the wire is at least partially packaged in the shape memory object, and a stress generated when the shape memory object deforms acts on the wire, to enable a current in the wire to be cut off.

2. The package structure (30) according to claim 1, wherein the shape memory object (37) is a polymer having one-way shape memory effect, or ceramic having one-way shape memory effect.

3. The package structure (30) according to claim 1, wherein the package structure further comprises a package medium (35), the power semiconductor device (31) is packaged in the package medium, a part of the wire (33) is packaged in the package medium, and a remaining part of the wire is packaged in the shape memory object (37).

4. The package structure (30) according to claim 1, wherein the package structure further comprises a package medium (35), the shape memory object (37) is a shape memory alloy having one-way shape memory effect, the shape memory object is packaged in the package medium, and the shape memory object is configured to deform when the temperature of the shape memory object reaches the preset temperature, to enable a current in the wire to be cut off.

5. The package structure (30) according to claim 4, wherein the wire (33) comprises a first extension part (331), a second extension part (333), and a connection part (335), a first end of the connection part is in electrical contact with the first extension part, a second end of the connection part is in electrical contact with the second extension part, and the shape memory object (37) is located between the first extension part and the second extension part.

6. The package structure (30) according to claim 5, wherein the shape memory object (37) and the connection part (335) of the wire are disposed at a spacing.

7. The package structure (30) according to claim 5, wherein the shape memory object (37) is disposed around an outer wall of the connection part (335).

8. The package structure (30) according to claim 7, wherein the shape memory object (37) is disposed closely adjacent to the connection part (335).

9. The package structure (30) according to claim 1, wherein the shape memory object (37) is a shape memory alloy having one-way shape memory effect, the package structure further comprises a solder formation (303), the solder formation is fastened to the wire (33), the solder formation is located outside the package medium (35), the shape memory object is implanted into the solder formation, one end of the shape memory object is electrically connected to the wire, and the shape memory object is configured to elongate when the temperature of the shape memory object reaches the preset temperature.

10. The package structure (30) according to any one of claims 4 to 9, wherein the shape memory object (37) is of an elastic structure, and an initial state of the shape memory object is a compressed state or a natural state.

11. An electronic apparatus (100), comprising the package structure (30) according to any one of claims 1 to 10 and a printed circuit board (10), wherein the package structure is fastened to the printed circuit board by using a solder formation (303), a control circuit (11) is disposed on the printed circuit board, the wire (33) of the package structure is electrically connected to the control circuit on the printed circuit board, and the control circuit is configured to control the power semiconductor device to turn on or off.

## Patentansprüche

1. Verpackungsstruktur (30), umfassend eine Leistungshalbleitervorrichtung (31), einen Draht (33) und ein Formspeicherobjekt (37), wobei der Draht elektrisch mit dem Leistungshalbleitervorrichtung verbunden ist, das Formspeicherobjekt in Kontakt mit dem Draht steht und so konfiguriert ist, dass es sich verformt, wenn seine Temperatur eine voreingestellte Temperatur erreicht, um eine Unterbrechung des Stroms im Draht zu ermöglichen, wobei das Formspeicherobjekt in isoliertem Kontakt mit dem Draht steht, der Draht zumindest teilweise in dem Formspeicherobjekt verpackt ist und eine bei der Verformung des Formspeicherobjekts erzeugte Spannung auf den Draht einwirkt, um eine Unterbrechung des Stroms im Draht zu ermöglichen.

2. Verpackungsstruktur (30) nach Anspruch 1, wobei das Formspeicherobjekt (37) ein Polymer mit Einweg-Formspeichereffekt oder eine Keramik mit Einweg-Formspeichereffekt ist.

3. Verpackungsstruktur (30) nach Anspruch 1, wobei die Verpackungsstruktur ferner ein Verpackungsmedium (35) umfasst, die Leistungshalbleitervorrichtung (31) in dem Verpackungsmedium verpackt ist, ein Teil des Drahtes (33) in dem Verpackungsmedium verpackt ist und ein verbleibender Teil des Drahtes in dem Formspeicherobjekt (37) verpackt ist.

4. Verpackungsstruktur (30) nach Anspruch 1, wobei die Verpackungsstruktur ferner ein Verpackungsmedium (35) umfasst, das Formspeicherobjekt (37) eine Formspeicherlegierung mit Einweg-Formspeichereffekt ist, das Formspeicherobjekt in dem Verpackungsmedium verpackt ist und das Formspeicherobjekt so konfiguriert ist, dass es sich verformt, wenn die Temperatur des Formspeicherobjekts die voreingestellte Temperatur erreicht, um eine Unterbrechung des Stroms im Draht zu ermöglichen.

5. Verpackungsstruktur (30) nach Anspruch 4, wobei der Draht (33) einen ersten Verlängerungsteil (331), einen zweiten Verlängerungsteil (333) und einen Verbindungsteil (335) umfasst, ein erstes Ende des Verbindungsteils in elektrischem Kontakt mit dem ersten Verlängerungsteil steht, ein zweites Ende des Verbindungsteils in elektrischem Kontakt mit dem zweiten Verlängerungsteil steht und sich das Formspeicherobjekt (37) zwischen dem ersten Verlängerungsteil und dem zweiten Verlängerungsteil befindet.

6. Verpackungsstruktur (30) nach Anspruch 5, wobei das Formspeicherobjekt (37) und der Verbindungsteil (335) des Drahtes mit einem Abstand angeordnet sind.

7. Verpackungsstruktur (30) nach Anspruch 5, wobei das Formspeicherobjekt (37) um eine Außenwand des Verbindungsteils (335) herum angeordnet ist.

8. Verpackungsstruktur (30) nach Anspruch 7, wobei das Formspeicherobjekt (37) eng benachbart zum Verbindungsteil (335) angeordnet ist.

9. Verpackungsstruktur (30) nach Anspruch 1, wobei das Formspeicherobjekt (37) eine Formspeicherlegierung mit Einweg-Formspeichereffekt ist, die Verpackungsstruktur ferner eine Lötverbindung (303) umfasst, die Lötverbindung am Draht (33) befestigt ist, die Lötverbindung sich außerhalb des Gehäusemediums (35) befindet, das Formspeicherobjekt in die Lötverbindung implantiert ist, ein Ende des Formspeicherobjekts elektrisch mit dem Draht verbunden ist und das Formspeicherobjekt so konfiguriert ist, dass es sich ausdehnt, wenn seine Temperatur die voreingestellte Temperatur erreicht.

10. Verpackungsstruktur (30) nach einem der Ansprüche 4 bis 9, wobei das Formspeicherobjekt (37) eine elastische Struktur aufweist und ein Anfangszustand des Formspeicherobjekts ein komprimierter Zustand oder ein natürlicher Zustand ist.

11. Elektronische Vorrichtung (100), umfassend die Verpackungsstruktur (30) nach einem der Ansprüche 1 bis 10 und eine Leiterplatte (10), wobei die Verpackungsstruktur unter Verwendung einer Lötverbindung (303) an der Leiterplatte befestigt ist, eine Steuerschaltung (11) auf der Leiterplatte angeordnet ist, der Draht (33) der Verpackungsstruktur elektrisch mit der Steuerschaltung auf der Leiterplatte verbunden ist und die Steuerschaltung dazu konfiguriert ist, das Ein- oder Ausschalten der Leistungshalbleitervorrichtung zu steuern.

## Revendications

1. Structure de boîtier (30), comprenant un dispositif semi-conducteur de puissance (31), un fil (33), et un objet à mémoire de forme (37), dans laquelle le fil est connecté électriquement au dispositif semi-conducteur de puissance, l'objet à mémoire de forme est en contact avec le fil, et l'objet à mémoire de forme est configuré pour se déformer lorsque la température de l'objet à mémoire de forme atteint une température prédéfinie, pour permettre la coupure d'un courant dans le fil, dans laquelle l'objet à mémoire de forme est en contact isolé avec le fil, le fil est au moins partiellement conditionné dans l'objet à mémoire de forme, et une contrainte générée lorsque l'objet à mémoire de forme se déforme agit sur le fil, pour permettre la coupure d'un courant dans le fil.

2. Structure de boîtier (30) selon la revendication **1,** dans laquelle l'objet à mémoire de forme (37) est un polymère présentant un effet de mémoire de forme unidirectionnel, ou une céramique présentant un effet de mémoire de forme unidirectionnel.

3. Structure de boîtier (30) selon la revendication 1, dans laquelle la structure de boîtier comprend également un support de boîtier (35), le dispositif semi-conducteur de puissance (31) est conditionné dans le support de boîtier, une partie du fil (33) est conditionné dans le support de boîtier, et une partie restante du fil est conditionnée dans l'objet à mémoire de forme (37).

4. Structure de boîtier (30) selon la revendication **1,** dans laquelle la structure de boîtier comprend également un support de boîtier (35), l'objet à mémoire de forme (37) est un alliage à mémoire de forme présentant un effet de mémoire de forme unidirectionnel, l'objet à mémoire de forme est conditionné dans le support de boîtier, et l'objet à mémoire de forme est configuré pour se déformer lorsque la température de l'objet à mémoire de forme atteint la température prédéfinie, pour permettre la coupure d'un courant dans le fil.

5. Structure de boîtier (30) selon la revendication 4, dans laquelle le fil (33) comprend une première partie d'extension (331), une seconde partie d'extension (333), et une partie de connexion (335), une première extrémité de la partie de connexion est en contact électrique avec la première partie d'extension, une seconde extrémité de la partie de connexion est en contact électrique avec la seconde partie d'extension, et l'objet à mémoire de forme (37) est situé entre la première partie d'extension et la seconde partie d'extension.

6. Structure de boîtier (30) selon la revendication 5, dans laquelle l'objet à mémoire de forme (37) et la partie de connexion (335) du fil sont disposés au niveau d'un espacement.

7. Structure de boîtier (30) selon la revendication 5, dans laquelle l'objet à mémoire de forme (37) est disposé autour d'une paroi extérieure de la partie de connexion (335).

8. Structure de boîtier (30) selon la revendication 7, dans laquelle l'objet à mémoire de forme (37) est disposé étroitement adjacent à la partie de connexion (335).

9. Structure de boîtier (30) selon la revendication 1, dans laquelle l'objet à mémoire de forme (37) est un alliage à mémoire de forme présentant un effet de mémoire de forme unidirectionnel, la structure de boîtier comprend également une formation de soudure (303), la formation de soudure est fixée au fil (33), la formation de soudure est située à l'extérieur du support de boîtier (35), l'objet à mémoire de forme est implanté dans la formation de soudure, une extrémité de l'objet à mémoire de forme est connectée électriquement au fil, et l'objet à mémoire de forme est configuré pour s'allonger lorsque la température de l'objet à mémoire de forme atteint la température prédéfinie.

10. Structure de boîtier (30) selon l'une quelconque des revendications 4 à 9, dans laquelle l'objet à mémoire de forme (37) est d'une structure élastique, et un état initial de l'objet à mémoire de forme est un état comprimé ou un état naturel.

11. Appareil électronique (100), comprenant la structure de boîtier (30) selon l'une quelconque des revendications 1 à 10 et une carte de circuit imprimé (10), dans lequel la structure de boîtier est fixée à la carte de circuit imprimé à l'aide d'une formation de soudure (303), un circuit de commande (11) est disposé sur la carte de circuit imprimé, le fil (33) de la structure de boîtier est connecté électriquement au circuit de commande sur la carte de circuit imprimé, et le circuit de commande est configuré pour commander le dispositif semi-conducteur de puissance pour s'allumer ou s'éteindre.
